# EUROPÄISCHE PATENTANMELDUNG

(11) **EP 1 046 959 A2**
(43) Veröffentlichungstag der Anmeldung: **25.10.2000**
(21) Anmeldenummer: 00890124.1
(22) Anmeldetag: 20.04.2000
(51) Int. Cl.: G03F 7/16, B05C 9/08

(54) **Vorrichtung zum Auftragen von Materialien auf Substrate, insbesondere zum Belacken von Si-Wafern**

(30) Priorität: 22.04.1999 AT 71199
(71) Anmelder: Thallner, Erich, Dipl.-Ing., A-4780 Schärding (AT)
(72) Erfinder: Thallner, Erich, Dipl.-Ing., A-4780 Schärding (AT)
(74) Vertreter: Hübscher, Heiner, Dipl.-Ing.

(57) **Zusammenfassung**

Bei einer Vorrichtung zum Auftragen von Materialien auf Substrate, insbesondere zum Belacken von Si-Wafern (9) mit photosensiblem Material, mit einer einen Träger (10) (Chuck) für das zu behandelnde Substrat aufnehmenden Behandlungskammer (1, 16) und wenigstens einer Zerstäuberdüse (2) zur Erzeugung eines dosierbaren, gegen das Substrat gerichteten Sprühstrahles aus dem aufzutragenden Material und einem Treibgas sind zur zusätzlichen Beeinflussung und Regelung des Sprühstrahles und dadurch der erzielbaren Auftragsgüte für das Material in der Behandlungskammer (1, 16) zwischen der bzw. den Zerstäuberdüsen (2) und dem Substratträger (10) zusätzliche Leit- und bzw. oder Aufbereitungseinrichtungen (6) vorgesehen, die mit Druckgas bzw. Druckgas und Lösungsmittel beschickbare Düsen oder Drallerzeuger und bzw. oder Schleuderscheiben, Kleinturbinen od. dgl. aufweisen und aus der von der bzw. den Zerstäuberdüsen (2) abgegebenen Sprühwolke den gezielt gegen das Substrat gerichteten Sprühstrahl erzeugen.

## Beschreibung

Die Erfindung betrifft eine Vorrichtung zum Auftragen von Materialien auf Substrate, insbesondere zum Belacken von Si-Wafern mit photosensiblem Material, mit einer einen Träger (Chuck) für das zu behandelnde Substrat aufnehmenden Behandlungskammer und wenigstens einer Zerstäuberdüse zur Erzeugung eines dosierbaren, gegen das Substrat gerichteten Sprühstrahles aus dem aufzutragenden Material und einem Treibgas. Die Erfindung betrifft auch Abwandlungen der Vorrichtung für die Behandlung von Materialien in der Mikroelektronik- und Mikrosystemtechnik, insbesondere auch Vorrichtungen zum Behandeln belichteter Wafer mit einer Entwicklungs- oder Ätzlösung.

Bekannte Belackungsvorrichtungen dieser Art ermöglichen keine hinreichend gleichmäßige Belackung und werden daher eher in der Leiterplattentechnik als für die Belackung von Si-Wafern mit photosensiblem Material verwendet.

Für die letztgenannten Zwecke wird bei anderen bekannten Vorrichtungen eine mittels einer Pumpe genau dosierte Menge an Photolack im Zentrum des Wafers angebracht und dann der Wafer in schnelle Drehung versetzt, wobei überflüssiger Lack abgeschleudert und eine Verteilung des Photolackes mit relativ hoher Gleichmäßigkeit auf ebenen Wafern erzielt werden kann. Dieses Verfahren wird derzeit für die benannten Zwecke am häufigsten gebraucht. Bei einem anderen Verfahren wird eine photosensible Schicht in Form einer Folie am Substrat angebracht. Zur Erzielung einer hohen Qualität und einer möglichst gleichmäßigen Schichtdicke auf ebenen Wafern wird auch teilweise mit geschlossenen Belackungskammern oder mitrotierenden Abdeckungen für den Wafer gearbeitet.

Für das Auftragen von Lackschichten auf stärker strukturierte Wafer oder Substrate, wie sie bei der Fertigung mikromechanischer Gebilde, z. B. barometrischer Dosen, oder bei sonstigen Gebilden für das Einlegen von Glasfasern, Leiterelementen, Flüssigkeiten usw. benötigt werden und wobei Kanäle oder Gräben ebenfalls möglichst gleichmäßig mit Photolack zu beschichten sind, sind derzeit noch keine voll befriedigenden Anlagen bekannt.

Aufgabe der Erfindung ist demnach die Schaffung einer Vorrichtung der eingangs genannten Art, die bei ihrer Ausbildung als Belackungsvorrichtung für Si-Wafer eine allen Anforderungen hinsichtlich Schichtdicke, Gleichmäßigkeit, Oberflächenstruktur und übrigem Aufbau entsprechende Belackung sowohl von ebenen als auch von strukturierten Wafern gewährleistet, wobei eine Anpassung an die Beschaffenheit des verwendeten Lackes möglich ist. Eine Teilaufgabe der Erfindung besteht auch in der Schaffung einer für das Auftragen anderer Materialien auf Substrate, z. B. für das Auftragen von Ätzlösungen auf belichtete Wafer, geeigneten Vorrichtung.

Die gestellte Aufgabe wird erfindungsgemäß prinzipiell dadurch gelöst, daß in der Behandlungskammer zwischen der bzw. den Zerstäuberdüsen und dem Substratträger zusätzliche Leit- und bzw. oder Aufbereitungseinrichtungen vorgesehen sind, die mit Druckgas bzw. Druckgas und Lösungsmittel beschickbare Düsen oder Drallerzeuger und bzw. oder Schleuderscheiben, Kleinturbinen od. dgl. aufweisen und aus der von der bzw. den Zerstäuberdüsen abgegebenen Sprühwolke den gezielt gegen das Substrat gerichteten Sprühstrahl erzeugen.

Der Grundgedanke der Erfindung besteht im wesentlichen darin, daß eine wesentlich günstigere und gezieltere Aufbereitung des aufzutragenden Materials erzielt werden kann, wenn zunächst an den Zerstäuberdüsen nur eine Sprühwolke gebildet und aus dieser Sprühwolke dann durch weitere Einrichtungen erst der gegen das Substrat gerichtete Sprühstrahl erzeugt wird. Bei der Belackung lassen sich dabei der Zerstäubungsgrad von Lack und Lösungsmittel und ihr Mengen- und Mischverhältnis genau einstellen, wobei diese Einstellung sogar während der Dauer einer Belackung variiert werden kann. Dies gilt auch für das Treibgas, wobei sogar im Bedarfsfall mit unterschiedlichen Temperaturen der den Sprühstrahl erzeugenden Materialien gearbeitet werden kann. Als Treibgas können herkömmliche Treibgase, die bei der Entspannung aus flüssiger in gasförmige Phase übergehen, eingesetzt werden. Besonders bevorzugt wird jedoch die Verwendung von Luft oder inerter Gase, z. B. Stickstoff.

Eine gewünschte, meist gleichmäßige Verteilung des Materials am Substrat wird dadurch begünstigt, daß die Leit- bzw. Aufbereitungseinrichtungen relativ zum Substratträger hinsichtlich ihres Abstandes und der Zielrichtung des Sprühstrahles auf das Substrat einstellbar sind. Der Abstand beeinflußt dabei auch die Aufprallgeschwindigkeit des zerstäubten Materials auf das Substrat.

Konstruktiv wird derzeit eine Ausbildung bevorzugt, bei der die Behandlungskammer die Grundform eines stehenden Prismas, insbesondere Hohlzylinders, aufweist, in ihr in Bodennähe die Zerstäuberdüse bzw. -düsen und die Leit- bzw. Aufbereitungseinrichtungen mit Abstand darüber angebracht sind, wobei der Substratträger an einem abnehmbaren Deckel der Behandlungskammer sitzt bzw. selbst deren Deckel bildet. Die Anordnung des Substratträgers am bzw. als Deckel erleichtert die Beschickung der Behandlungskammer und ermöglicht es auch, das Substrat nach der Beschichtung, insbesondere Belackung, allenfalls in eine Abstropfstation oder in eine Trockenstation zu überführen. Auch bei der Behandlung anderer Substrate mit Äztlösungen usw. hat die beschriebene Konstruktion die aufgezeigten Vorteile. Wenn der Deckel der Größe des Substratträgers und dessen Größe wieder etwa dem Substrat entspricht, ergibt sich eine im Volumen relativ kleine Behandlungskammer, in deren unterem Teil die Zerstäuberdüse bzw. -düsen einen Materialnebel erzeugen, aus dem dann über die Leit- oder Aufbereitungseinrichtungen der Sprühstrahl erzeugt wird. Bei Photolacken zeigt sich, daß im unteren Bereich der Behandlungskammer ein relativ größerer Anteil an größeren, durch die Zerstäuberdüsen erzeugten Tröpfchen vorhanden ist als im oberen Bereich. Durch verschieden hohe Einstellung der Leit- bzw. Aufbereitungseinrichtungen, also deren Eintauchtiefe in den Nebel, kann man eine Auswahl hinsichtlich der gewünschten Tröpfchengröße treffen, wobei diese Tröpfchen im Normalfall aber durch die Aufbereitungseinrichtungen selbst noch einmal unterteilt und beschleunigt werden.

Die Einstellmöglichkeiten werden noch dadurch erhöht, daß die Behandlungskammer aus einem Oberteil, einem Unterteil und dem den Substratträger aufweisenden Deckel besteht, wobei der die Zerstäuberdüse bzw. -düsen enthaltende Unterteil den Boden und einen Teil der Seitenwandung der Kammer aufweist, teleskopisch in dessen Längsrichtung relativ zum Oberteil verstellbar angebracht ist und die Leit- bzw. Aufbereitungseinrichtungen im Oberteil einstellbar gehalten sind. Es können hier sowohl das Kammervolumen als auch die Abstände zwischen Zerstäuberdüsen und Leiteinrichtungen bzw. Leiteinrichtungen und Substratträger jeweils für sich eingestellt werden. Zumindest im Bodenbereich der Behandlungskammer kann ein Ablauf für sich an ihrem Boden oder ihren Wandungen niederschlagendes Material vorgesehen werden.

Je nach der Art der durchzuführenden Behandlung kann man die Art, wie das Substrat vom Sprühstrahl überstrichen wird, auf verschiedene Weise einstellen. Im einfachsten Fall werden nur die Leit- bzw. Aufbereitungseinrichtungen relativ zum Substrat verstellt oder das Substrat mit Hilfe des Substratträgers relativ zu dem Sprühstrahl bewegt. Auch beide Bewegungsarten sind möglich. Eine zusätzliche Verbesserung der Verteilung des Materials am Substrat läßt sich erzielen, wenn der Substratträger, wie an sich bekannt, rotierend antreibbar und bzw. oder mit einem Schwingungserzeuger gekuppelt ist. Durch den rotierenden Antrieb kann man auch überschüssig aufgetragenes Material entfernen. Vorteilhaft wird aber ein derartiges Abschleudern von Material nur bei im wesentlichen glattem Substrat vorgenommen, da sich bei stärker strukturierten Substraten eine oft unerwünschte, ungleichmäßige Verteilung der Beschichtung über die Strukturen ergeben könnte. Hier wird eine Vibration des Substratträgers die gewünschte Vergleichmäßigung des aufgetragenen Materials bewirken.

Nach einer Weiterbildung ist die Behandlungskammer zwischen den Leit- bzw. Aufbereitungseinrichtungen und dem Substratträger durch eine Trennwand unterteilbar. Diese Ausführung hat den wesentlichen Vorteil, daß in dem von der Trennwand abgeschlossenen unteren Bereich der Behandlungskammer der Materialnebel erhalten bleibt und beim Auswechseln des Substrates nur der vom Volumen her meist nur sehr kleine Oberteil der Behandlungskammer geöffnet werden muß. Man kann auch überschüssig aufgetragenes Material erst nach Schließen der Trennwand abstreifen oder abschleudern, so daß durch entsprechende Tröpfchen keine Störung für den Betrieb zu erwarten ist. Bei der Einbringung eines neuen Substrates ist nach dem Öffnen der Trennwand in kürzester Zeit wieder die gewünschte Kammeratmosphäre mit der Möglichkeit zur Sprühstrahlbildung herstellbar.

Für den zwischen Substratträger und Trennwand eingeschlossenen Bereich der Behandlungskammer können zusätzliche Ableit- oder Absaugvorrichtungen vorgesehen werden.

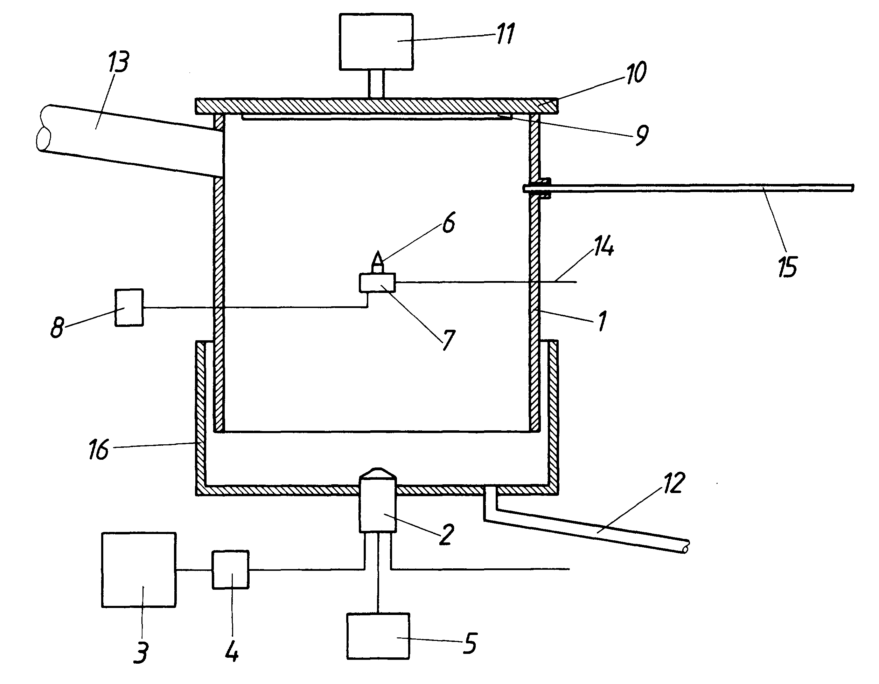

Weitere Einzelheiten und Vorteile des Erfindungsgegenstandes entnimmt man der nachfolgenden Zeichnungsbeschreibung. In der Zeichnung ist als Ausführungsbeispiel des Erfindungsgegenstandes eine Vorrichtung zum Belacken von Si-Wafern mit photosensiblem Material in stark vereinfachtem Schema im Schnitt durch die Behandlungskammer veranschaulicht.

Die Vorrichtung besitzt eine in der Grundform hohlzylindrische Behandlungskammer mit einem rohrförmigen Oberteil 1 und einem den Boden und einen Teil der Seitenwandung bildenden Unterteil 16, aus dem der Oberteil 1 teleskopisch ausziehbar ist. Im Unterteil 16 ist beim Ausführungsbeispiel innerhalb des Bodens wenigstens eine Zerstäuberdüse 2 angebracht, die aus einem Behälter 3 über eine Pumpe 4 mit Photolack beschickbar ist und der auch über eine Leitung aus einem Vorratsbehälter 5 ein Lösungsmittel sowie über eine weitere Leitung ein Treibgas, z. B. N₂ zugeführt werden kann. Die Zerstäuberdüse 2 kann eine Druckgaszerstäuberdüse oder auch eine piezzoerregte Zerstäuberdüse sein. Beim Betrieb erzeugt sie aus den zugeführten Materialien eine Sprühwolke, wobei durch Änderung des Druckes und der Zusammensetzung eine mittlere Tröpfchengröße eingestellt werden kann. Vor der Inbetriebnahme wird die gesamte Behandlungskammer vorzugsweise mit einem inerten Gas, z. B. N₂, gefüllt.

Im Oberteil 1 der Behandlungskammer ist eine beim Ausführungsbeispiel als Düse 6 eingezeichnete Leit- und Aufbereitungseinrichtung vorgesehen, die über eine Bewegungseinheit 7 sowohl der Höhe nach als auch nach der Seite und in ihrer Neigung einstellbar ist und die aus der sie umgebenden Sprühwolke Material entnimmt und zu einem gerichteten Sprühstrahl aufbereitet. Die Bewegungseinheit 7 kann von einer Steuereinheit 8 gesteuert werden. Der erzeugte Sprühstrahl ist gegen ein Substrat 9, insbesondere einen Si-Wafer, gerichtet, der an einem zugleich den Deckel der Behandlungskammer bildenden Substratträger 10 z. B. durch Vakuum gehalten wird und gegebenenfalls über eine Antriebseinheit 11 in Rotation versetzt werden kann. Durch diese verschiedenen Einstellmöglichkeiten kann man je nach Wunsch eine gleichmäßige oder auch eine gezielt ungleichmäßige Belackung des Substrates 9 erzeugen. An den Unterteil 16 schließt ein Ablauf 12 für überschüssiges Material an. Ferner ist ein Anschluß 13 für eine Absaugvorrichtung vorhanden. Die Düse 6 kann zusätzlich über eine Leitung 14 mit einem Treibgas (N₂) und gegebenenfalls einem Lösungsmittel, das an der Düse 6 versprüht oder verdampft wird, beschickt werden. Bei geschlossenem Behälter herrscht in seinem Innenraum eine hohe Sättigung der Atmosphäre mit Lösungsmittel, so daß eine Eintrocknung des Lacknebels verhindert wird.

Zwischen der Düse 6 und dem Substratträger 10 ist die Kammer durch eine einschiebbare Trennwand 15 abteilbar, so daß der gesamte untere Bereich von einem Öffnen des den Substratträger 10 bildenden Deckels unbeeinflußt bleibt und der obere Bereich vorher über die Leitung 13 entleert werden kann. Bei geschlossener Trennwand ist auch ein Abschleudern von überschüssigem Lack durch drehenden Antrieb des Substratträgers 10 möglich, ohne daß dadurch Turbulenzen in der Atmosphäre des Hauptraumes der Behandlungskammer entstehen. Die Düse 6 kann als einfache Beschleunigerdüse, aber auch als Venturidüse ausgeführt sein, wobei nach einer Variante bei dieser Venturidüse noch ein Außenmantel vorgesehen ist, der für sich mit Treibgas beschickbar ist, so daß der aus der Düse austretende Sprühstrahl durch den umgebenden Treibgasmantel günstiger stabilisiert wird. Die Düse 6 kann auch einen Drallerzeuger enthalten. Nach einer anderen Ausführungsform wird die Düse mit einem Drallerzeuger kombiniert oder statt der Düse bzw. in Verbindung mit ihr eine Schleuderscheibe oder eine Kleinturbine vorgesehen, die jeweils einen gegen das Substrat 9 gerichteten Sprühstrahl erzeugen.

Eine ähnliche Ausführungsform der Vorrichtung kann auch gewählt werden, wenn in einer Kammer ein an einem Träger gehaltenes Substrat mit anderen Materialien behandelt werden soll, z. B. wenn ein mit einer Photolackbeschichtung versehener Si-Wafer nach der Belichtung gegen eine Maske mit einem Entwickler und einer Ätzlösung behandelt werden.

## Patentansprüche

1. Vorrichtung zum Auftragen von Materialien auf Substrate, insbesondere zum Belacken von Si-Wafern (9) mit photosensiblem Material, mit einer einen Träger (10) (Chuck) für das zu behandelnde Substrat aufnehmenden Behandlungskammer (1, 16) und wenigstens einer Zerstäuberdüse (2) zur Erzeugung eines dosierbaren, gegen das Substrat gerichteten Sprühstrahles aus dem aufzutragenden Material und einem Treibgas, dadurch gekennzeichnet, daß in der Behandlungskammer (1, 16) zwischen der bzw. den Zerstäuberdüsen (2) und dem Substratträger (10) zusätzliche Leit- und bzw. oder Aufbereitungseinrichtungen (6) vorgesehen sind, die mit Druckgas bzw. Druckgas und Lösungsmittel beschickbare Düsen oder Drallerzeuger und bzw. oder Schleuderscheiben, Kleinturbinen od. dgl. aufweisen und aus der von der bzw. den Zerstäuberdüsen (2) abgegebenen Sprühwolke den gezielt gegen das Substrat gerichteten Sprühstrahl erzeugen.

2. Vorrichtung nach Anspruch 1, dadurch gekennzeichnet, daß die Leitbzw. Aufbereitungseinrichtungen (6) relativ zum Substratträger (10) hinsichtlich ihres Abstandes und der Zielrichtung des Sprühstrahles auf das Substrat (9) einstellbar sind.

3. Vorrichtung nach Anspruch 1 oder 2, dadurch gekennzeichnet, daß die Behandlungskammer (1, 16) die Grundform eines stehenden Prismas, insbesondere Hohlzylinders, aufweist, in ihr in Bodennähe die Zerstäuberdüse (2) bzw. -düsen und die Leit- bzw. Aufbereitungseinrichtungen (6) mit Abstand darüber angebracht sind und daß der Substratträger (10) an einem abnehmbaren Deckel der Behandlungskammer (1, 16) sitzt bzw. selbst deren Deckel bildet.

4. Vorrichtung nach einem der Ansprüche 1 bis 3, dadurch gekennzeichnet, daß die Behandlungskammer (1, 16) aus einem Oberteil (1), einem Unterteil (16) und dem den Substratträger aufweisenden Deckel (10) besteht, wobei der die Zerstäuberdüse (2) bzw. -düsen enthaltende Unterteil (16) den Boden und einen Teil der Seitenwandung der Kammer aufweist, teleskopisch in dessen Längsrichtung relativ zum Oberteil (1) verstellbar angebracht ist und die Leit- bzw. Aufbereitungseinrichtungen (6) im Oberteil (1) einstellbar gehalten sind.

5. Vorrichtung nach einem der Ansprüche 1 bis 4, dadurch gekennzeichnet, daß zumindest im Bodenbereich (16) der Behandlungskammer ein Ablauf (12) für sich an ihrem Boden oder ihren Wandungen niederschlagendes Material vorgesehen ist.

6. Vorrichtung nach einem der Ansprüche 1 bis 5, dadurch gekennzeichnet, daß der Substratträger (10), wie an sich bekannt, rotierend antreibbar und bzw. oder mit einem Schwingungserzeuger gekuppelt ist.

7. Vorrichtung nach einem der Ansprüche 1 bis 6, dadurch gekennzeichnet, daß die Behandlungskammer (1, 16) zwischen den Leit- bzw. Aufbereitungseinrichtungen (6) und dem Substratträger (10) durch eine Trennwand (15) unterteilbar ist.

8. Vorrichtung nach Anspruch 7, dadurch gekennzeichnet, daß für den zwischen Substratträger (10) und Trennwand (15) eingeschlossenen Bereich der Behandlungskammer (1, 16) zusätzliche Ableit- oder Absaugvorrichtungen (13) vorgesehen sind.
